# FASCICULE DE BREVET EUROPEEN

(11) **EP 2 387 626 B1**
(45) Date de publication et mention de la délivrance du brevet: **26.06.2013**
(21) Numéro de dépôt: 10702517.3
(22) Date de dépôt: 08.01.2010
(51) Int. Cl.: C23C 16/18, C07F 15/00, H01L 21/285, H01M 4/88, H01M 4/92, H01L 21/768

(54) **COMPLEXES ORGANOMETALLIQUES POUR LE DEPOT CHIMIQUE EN PHASE VAPEUR DE PLATINE**
ORGANOMETALLKOMPLEXE FÜR DIE CHEMISCHE GASPHASENABSCHEIDUNG VON PLATIN
ORGANOMETAL COMPLEXES FOR CHEMICAL VAPOUR DEPOSITION OF PLATINUM

(30) Priorité: 15.01.2009 FR 0900165
(43) Date de publication de la demande: 23.11.2011
(73) Titulaire: Centre National de la Recherche Scientifique CNRS, 75016 Paris (FR)
(72) Inventeur: DOPPELT, Pascal, F-93130 Noisy-le-Sec (FR); THURIER, Cyril, F-45100 Orleans (FR)
(74) Mandataire: Majidi, Assieh
(86) Numéro de dépôt international: PCT/FR2010/000013
(87) Numéro de publication internationale: WO 2010/081959

(56) Documents cités:
- GB-A- 906 018
- JP-A- 2009 038 097
- US-A- 3 105 084
- NICOLA OBERBECKMANN: "Die Einfflhrung vonfunktionalisierten Cyclopentadienyl-Liganden an Platin(II)-Zentren flber Diolefin-Platin-Komplexe" 2001, , XP008106208 pages 23,32-33
- TONY DEBAERDEMAEKER, CLAUS WEISEMANN: "Platin-kolhenstoff-a-bidungen mit gehinderte rotation: chloro(2-alkoxynaphth-1-yl)..." JOURNAL OF ORGANOMETALLIC CHEMISTRY, 1988, pages 91-99, XP008106218 The Nederlands
- CANADIAN JOURNAL OF CHEMISTRY 1996 NOV NATL RESEARCH COUNCIL OF CANADA, vol. 74, no. 11, novembre 1996 (1996-11), pages 2008-2017, XP008106103 & DATABASE COMPENDEX [Online] ENGINEERING INFORMATION, INC., NEW YORK, NY, US; 1 novembre 1996 (1996-11-01), APPLETON TREVOR G ET AL: "Synthesis of dimethylplatinum(IV) compounds, [{PtMe2X2}n], [{PtMe2XY}n], and, in solution, fac-[PtMe2X(H2O)3]<+>, where X and Y are anionic ligands" Database accession no. EIX97123506713
- TREVOR G APPLETON ET AL: "Displacement of norbornadiene (NBD) from PtMe2(NBD) BY N-donors, dimethylsulfoxide, and cyanide, and reactions of cis-PtMe2L2 iodomethane" JOURNAL OF ORGANOMETALLIC CHEMISTRY, ELSEVIER-SEQUOIA S.A. LAUSANNE, CH LNKD- DOI:10.1016/0022-328X(86)80119-X, vol. 303, no. 1, 1 avril 1986 (1986-04-01) , pages 139-149, XP008106261 ISSN: 0022-328X [extrait le 2001-04-16]
- DELL'AMICO ET AL: "Competition between carbon monoxide and alkenes in chloro complexes of platinum(II)" ORGANOMETALLICS,, 1 janvier 2005 (2005-01-01), pages 4427-4431, XP002598038
- CLARK ET AL: "Reactions of (pi-1,5-cyclooctadiene)organoplatinum(II) compounds and tzhe synthesis of perfluoroalkylplatinum complexes" JOURNAL OF ORGANOMETALLIC CHEMISTRY,, 1 janvier 1973 (1973-01-01), pages 411-428, XP002598039
- OGAWA ET AL: "product class 3: organometallic complexes of platinum" SCIENCE OF SYNTHESIS,, 1 janvier 2002 (2002-01-01), pages 389-437, XP002598040

## Description

L'Invention a pour objet un procédé pour l' utilisation de nouveaux complexes de platine pour l'utilisation de nouveaux complexes de platine pour le dépôt chimique en phase gazeuse de platine métallique. Elle concerne un procédé de fabrication d'un film ou d'une dispersion de platine ainsi qu'un composant d'un dispositif électronique et un catalyseur comprenant un tel film ou une telle dispersion de platine.

Les films fins de platine et les dispersions de particules de platine sont largement utilisés en micro-électronique, par exemple pour fabriquer les contacts de diodes ohmiques ou Schottky, les films barrières de diffusion, comme revêtements pour des matériaux soumis à des températures élevées et pour la fabrication de catalyseurs solides supportés. Parmi toutes les méthodes de dépôt de métaux, la méthode de dépôt chimique en phase vapeur d'un composé organométallique (également nommée méthode MOCVD ou plus simplement CVD pour «metalo-organic chemical vapor deposition ») donne de très bons résultats en termes de coûts, de températures de traitement, de durées, de pouvoir couvrant et de qualité générale du dépôt.

La possibilité de former un dépôt métallique satisfaisant par la méthode MOCVD dépend de la volatilité du composé précurseur. En effet, cette méthode requiert la possibilité d'obtenir une pression de vapeur élevée du composé précurseur et une stabilité élevée de ce même composé.

Le principe du MOCVD est de vaporiser un précurseur volatil du métal, à savoir un complexe organométallique, qui va venir se décomposer thermiquement sur le substrat pour former une couche métallique. En pratique la vaporisation se fait dans des conditions de pression et de température permettant d'obtenir une tension de vapeur du précurseur suffisante pour le dépôt, tout en restant dans son domaine de stabilité. Le substrat quant à lui est chauffé au-delà de ce domaine de stabilité, ce qui permet la décomposition de l'assemblage organométallique et la formation de particules de métal. La méthode de dépôt par CVD présente différents avantages sur les autres méthodes connues : la température de thermolyse en CVD de composés organométalliques est 1 à 2 milliers de degrés plus basse que pour les autres techniques de dépôt en phase vapeur. Les films obtenus sont denses et continus, ce qui permet d'éviter une porosité incompatible avec de bonnes propriétés électriques. Contrairement à la méthode par imprégnation liquide, cette méthode est rapide et les étapes d'imprégnation, de lavage, de séchage, de calcination et d'activation sont évitées. Sont évités également, l'empoisonnement de la surface et les modifications du matériau activé durant le séchage. C'est donc une méthode rapide et économique pour obtenir des dépôts contrôlés de bonne qualité.

Différents composés organométalliques de Pt, qui sont des complexes contenant du platine et des ligands organiques, sont actuellement très utilisés. On peut citer notamment : Pt(acac)₂, Pt(PF₃)₄, (cod)PtMe₂, MeCpPtMe₃ ou EtCpPtMe₃. Ces composés, également appelés ici précurseurs, sont largement décrits dans la littérature.

Ces précurseurs connus ont les formules suivantes :

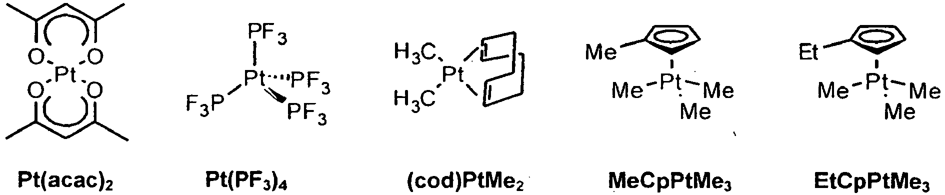

Ainsi, dans la présente demande, les abréviations suivantes désignent les groupements suivants :
- (acac)₂ : bis-acétylacétonate,
- (cod) : 1,5-cyclootadiène,
- (Cp) : cyclopentadiènyle.

Cependant, chacun de ces précurseurs présente des limites qui constituent un inconvénient pour leur mise en oeuvre dans un procédé MOCVD dans un contexte industriel.

Ainsi, différentes études ont montré que des problèmes de décomposition sont rencontrés lors de l'utilisation de Pt(acac)₂ : le ligand peut se décomposer sans se décoordonner du métal, ce qui conduit généralement à un dépôt renfermant une quantité élevée d'impuretés.

Pt(PF₃)₄ conduit à un dépôt contenant du fluor, ce qui est rédhibitoire pour certaines applications (Martin T.P. et *al*., J.Chem. Vap. Déposition, 2005, 11, 170-174)

(cod)PtMe₂ est un précurseur intéressant mais il a une volatilité modérée, ce qui impose de travailler à des températures plus élevées comparativement aux autres complexes du platine. De plus, avec ce précurseur utilisé en solution, on observe des dépôts dotés de propriétés non reproductibles, ce qui laisse supposer un manque de stabilité de la solution de ce précurseur lors d'un stockage à long terme.

CpPtMe₃ est sensible à l'air et à l'humidité.

Quant à MeCpPtMe₃, il est sensible à l'air et à l'humidité et son coût est élevé.

Son analogue EtGpPtMe₃ présente une meilleure stabilité mais tout comme MeCpPtMe₃, il est coûteux.

L'invention vise à pallier les inconvénients des composés précurseurs organométalliques de platine de l'art antérieur en proposant l'utilisation de précurseurs organométalliques de platine, stables à température ambiante mais facilement décomposables à une température modérée, volatils, et à prix de revient avantageux car pouvant être fabriqués par un procédé comportant seulement une ou deux étapes.

A cet effet, l'invention propose l'utilisation des composés organométalliques de platine qui comprennent un ligand à structure cyclique comprenant au moins deux doubles liaisons C=C non adjacentes, et qui ont une structure plan-carré dans laquelle le platine est lié à chacune des doubles liaisons C=C du ligand en formant un angle (C=C)-Pt-(C=C) compris entre 60 et 70°.

De préférence, l'angle (C=C)-Pt-(C=C) est compris entre 64 et 66° et avantageusement égal à environ 65°.

Selon l'invention, le ligand des composés organométalliques de l'invention a la formule (I) suivante : 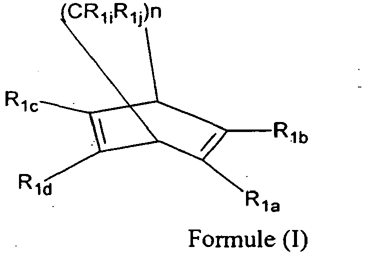 dans laquelle :
- n représente un entier choisi parmi 1 et 2,
- lorsque n=1, R₁ᵢ, R₁ⱼ représentent chacun un seul groupement, lorsque n=2, R₁ᵢ et R₁ⱼ représentent chacun deux groupements identiques ou différents,
- R₁ₐ, R_{1b}, R_{1c}, R_{1d}, R₁ᵢ, R_{1j,} identiques ou différents, sont choisis parmi : H, un atome d'halogène, un groupe alkyle en C₁ à C₄, un groupe trialkyl silane en C₁-C₄, un groupe alcényle en C₂ à C₄, un groupe alkyle en C₁ à C₄ porteur d'une ou plusieurs fonctions OH.

Par atome d'halogène, on entend un atome choisi parmi : F, Cl, I, Br.

Les groupes alkyle et alcényle peuvent être linéaire ou ramifiés.

Par groupe trialkyl silane en C₁-C₄ on entend un groupe silane constitué d'un atome Si porteur de trois substituants alkyle en C₁-C₄, identiques ou différents. De préférence les trois substituants alkyle sont identiques.

De préférence, dans les composés de formule (I), l'une ou plusieurs des conditions suivantes est vérifiée :
- n=1,
- R_{1b}, R_{1c}, R_{1d}, R₁ⱼ sont tous identiques et représentent H,
- R₁ₐ est choisi parmi : H, Cl, le méthyle, l'éthyle, le n-propyle, l'isopropyle, le tertiobutyle, le triméthylsilane, le propèn-3-yle, l'éthanol,
- R₁ᵢ est choisi parmi : H, le méthyle, l'éthyle.

Le plus préférablement, dans la formule (I), R₁ₐ est choisi parmi : H, le méthyle, l'éthyle, le n-propyle, l'isopropyle, le triméthylsilane.

Selon l'invention, les composés organométalliques de platine répondent à la formule (II) suivante : 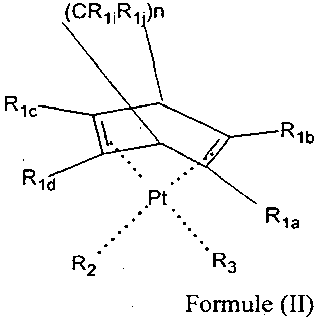 dans laquelle n et R₁ₐ, R_{1b}, R_{1c}, R_{1d}, R₁ᵢ, R₁ⱼ sont tels que défini ci-dessus pour la formule (I), avec les mêmes variantes préférées, et R₂ et R₃ sont choisis chacun indépendamment l'un de l'autre parmi les alkyles linéaires en C₁ à C₄.

De préférence, dans la formule (II), R₂ et R₃ sont identiques et sont choisis parmi : le méthyle, l'éthyle.

Des composés organométalliques de platine particulièrement préférés pour la mise en oeuvre du procédé de l'invention sont les composés de formule (II-A), (II-B), (II-C), (II-D), (II-E) et (II-F) suivantes :

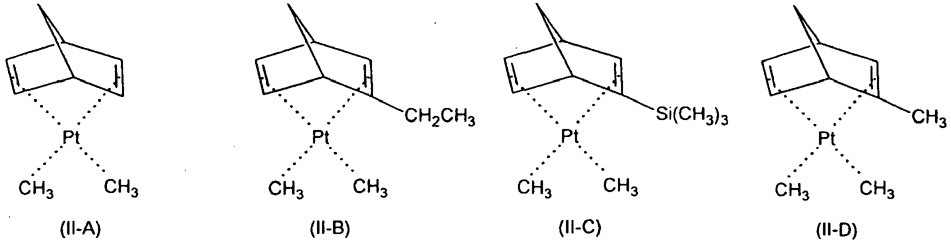

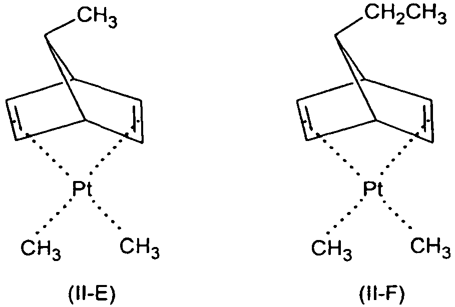

L'invention repose sur la découverte que les composés de formule (II) sont, de manière surprenante, plus stables à température ambiante que des composés organométalliques de même type dans lesquels l'angle (C=C)-Pt-(C=C) vaut ou est proche de 90°.

Ces composés organométalliques de platine ont une structure plan-carré autour du platine due à un effet Ian-Teller bien connu pour un ion d'un métal de transition de structure électronique 5d⁸ tel que le Pt²⁺.

De plus, ces composés organométalliques (II) sont plus facilement évaporables ou sublimables à des températures plus basses que ceux de l'art antérieur, et libèrent le platine à cette température modérée tout en volatilisant rapidement les éléments carbonés des composés organométalliques utilisés dans l'invention comme cela est illustré dans la partie expérimentale.

De préférence, l'angle (C=C)-Pt-(C=C) est proche de 65°, c'est-à-dire est égal à environ 65°.

La structure du composé de formule (II-A) utilisé dans l'invention comme celle du composé (cod)PtMe₂ de l'art antérieur est une structure plan-carré. Sur le schéma 1 ci-dessous sont illustrées les données obtenues par diffraction des rayons X sur des monocristaux de ces deux précurseurs du platine dans lesquels le platine est sous forme Pt ²⁺ : distances entre atomes et angles entre les liaisons.

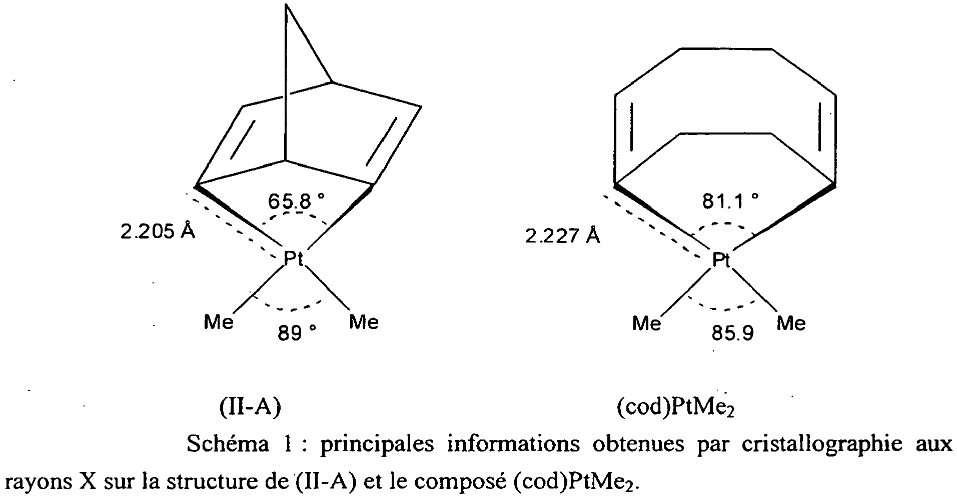

De ces données a pu être déduite la structure plan-carré de ces deux molécules. Néanmoins une différence importante est que, dans le cas du composé de l'art antérieur, les angles Me-Pt-Me et (C=C)-Pt-(C=C) sont proches de 90° (un angle de 90° correspond à la configuration plan-carré idéale) et que dans le cas du composé de formule (II-A) de l'invention, les contraintes de rigidité du ligand norbornadiène et la faible distance entre les deux doubles liaisons imposent un angle (C=C)-Pt-(C=C) plus faible, de 65,8°.

Cette contrainte, plus grande dans la molécule, aurait du conduire à une structure moins stable et à une énergie de liaison entre le platine et le ligand norbornadiène plus faible que pour la liaison avec le ligand cyclooctadiène du composé de l'art antérieur.

Cependant, de façon surprenante, il a été constaté expérimentalement que le composé de formule (II-A) est plus stable à température ambiante tout en ayant une meilleure volatilité que le composé (cod)PtMe₂ de l'art antérieur.

En effet, des études par RMN (résonance magnétique nucléaire) du ¹H ont montré qu'en solution le composé de formule (II-A) se dégrade moins rapidement que le (cod)PtMe₂ de l'art antérieur. Ces études RMN ont été effectuées à partir de solutions de précurseurs 5.¹⁰⁻² M dans le chloroforme deutérié (ni séché, ni dégazé) en utilisant le tétraméthylsilane (TMS) comme étalon interne.

Mais ces études ont également montré que les composés organométalliques de formule (II) de l'invention dans lesquels le substituant R₁ₐ est non pas H comme dans le composé de formule (II-A) mais un groupe méthyle, ou éthyle ou SiMe₃ ne montraient aucune sensibilité marquée vis-à-vis de l'oxygène et de l'eau.

Il a ainsi été constaté que lorsque les composés organométalliques de platine ont une structure plan-carré dans laquelle l'angle (C=C)-Pt-(C=C) est compris entre 60 et 70°, leur stabilité à température ambiante est augmentée et leur volatilité à une température modérée est augmentée.

Les composés organométalliques de platine de l'invention ont ainsi une stabilité au stockage supérieure à celle du composé (cod)PtMe₂ de l'art antérieur.

En effet, après un stockage de six jours à température ambiante sous azote, seulement 5% du composé de formule (II-A) s'étaient décomposés. Cependant, aucune décomposition n'était détectable lorsque le composé de formule (II-A) était stocké à l'abri de la lumière durant cette période.

Dans les mêmes conditions, 50% du composé précurseur (cod)PtMe₂ de l'art antérieur étaient décomposés.

L'influence de l'introduction d'un substituant sur le ligand norbornadiène sur les propriétés des composés de l'invention a été estimée par l'observation de l'aspect du composé organométallique et par spectroscopie RMN du proton.

Ainsi, lorsque les ligands liés au platine (R₂ et R₃) sont un méthyle, le composé de formule (II-A) est plus stable que le composé de formule (II-B) qui est lui-même plus stable que le composé de formule (II-C).

En ce qui concerne les 7-norbornadiènes substitués dans lesquels un hydrogène sur le carbone en position 7 (le C du pont) est substitué par un groupement Me ou Et, comme par exemple les composés (II-E) et (II-F), on a constaté que la présence de ces groupements augmente le volume stérique de la molécule sans peser sur les interactions stériques des 2 groupements CH₃ liés au platine qui limitent la stabilité du précurseur. Par conséquent, la volatilité du précurseur est augmentée, son point de fusion est diminué (en général, des précurseurs liquides sont préférés) tout en conservant une bonne stabilité.

La nature des substituants liés au platine, c'est-à-dire de R₂ et R₃, influence également la stabilité des composés organométalliques selon l'invention.

Ainsi, lorsque R₂ et R₃ représentent tous deux un éthyle, le composé obtenu est moins stable que le composé dans lequel R₂ et R₃ représentent tous deux un méthyle, pour un même ligand norbornadiène substitué ou non.

Mais tous les composés utilisés dans l'invention sont significativement plus stables que le composé (cod)PtMe₂ de l'art antérieur.

Par ailleurs, les composés organométalliques de platine utilisés dans l'invention sont très volatils à des températures modérées.

Deux procédés distincts permettant de fabriquer les composés de formule (II) ont été mis au point. Toutefois, les composés de formule (II) peuvent également être préparés en appliquant des procédés connus de l'art antérieur comme notamment ceux décrits dans Appleton T.G. et al., Journal of Organometallic Chemistry, 303, 1986, 139-149.

Un premier procédé de fabrication d'un composé organométallique est représenté sur le schéma 2 ci-dessous.

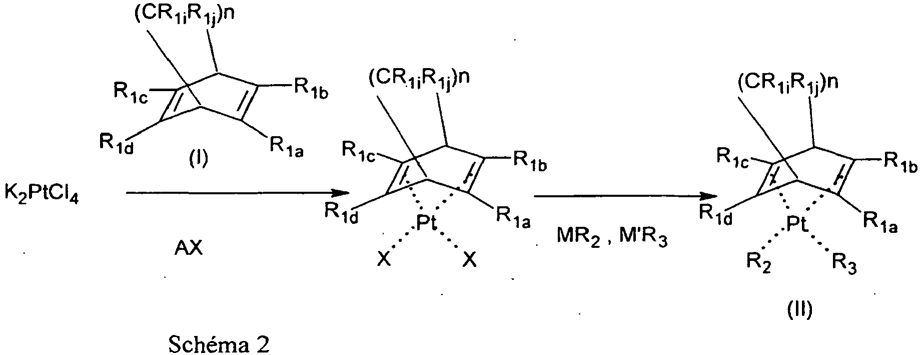

Ce procédé comprend une première étape de réaction d'un ligand de formule (I) telle que définie ci-dessus, avec K₂PtCl₄, en présence d'un sel d'halogénure AX dans un milieu protique. X est choisi parmi Cl, Br et I. A peut par exemple être choisi parmi K, Na, Ag, ou NH₄, de préférence X=I. Le milieu peut être simplement de l'eau ou un alcool tel que du méthanol, de l'éthanol, du propanol, du butanol, un acide tel qu'une solution aqueuse d'acide acétique, ou encore un mélange de ces solvants. Dans une seconde étape, le composé ainsi obtenu réagit avec un composé organométallique de formule R₂M et/ou un composé organométallique de formule R₃M' dans lesquelles R₂ et R₃ sont tels que définis ci-dessus et M, M' sont des atomes de métal.

De préférence, dans ce procédé le sel d'halogénure AX est KI.

Egalement de préférence, dans la formule R₂M et/ou la formule R₃M', le métal M et/ou M' est choisi parmi Li, Na, Mg, A1 ou Sn, et le milieu protique est un mélange d'eau et de *sec*-propanol.

Le plus préférablement, dans la formule R₂M ou la formule R₃M', le métal M et/ou M' est le lithium, Li.

De préférence K₂PtCl₄ et le dérivé norbornadiène sont introduits en quantités sensiblement équivalentes en moles. De façon avantageuse la première étape de réaction de ce procédé se fait en présence d'un excès de sel AX par rapport aux réactifs K₂PtCl₄ et au norbornadiène, avantageusement entre 3 et 5 équivalents molaires de sel AX par rapport aux réactifs K₂PtCl₄ et au norbornadiène.

Un autre procédé de fabrication d'un composé organométallique (II) est décrit dans le schéma 3 ci-dessous :

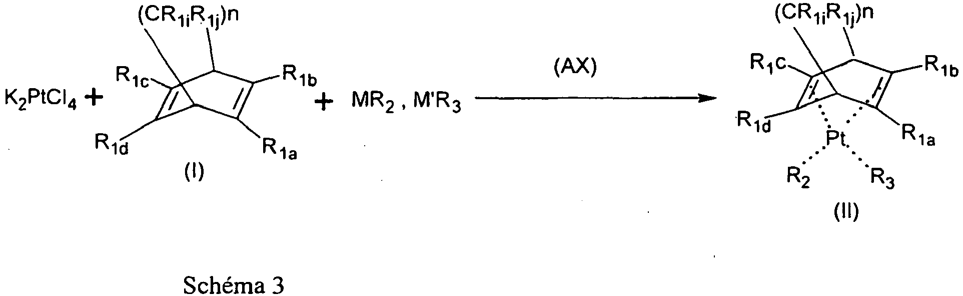

Ce procédé en une seule étape consiste à faire réagir, à température ambiante, un ligand de formule (I) telle que définie ci-dessus avec K₂PtCl₄ et un composé organométallique de formule R₂M et/ou un composé organométallique de formule R₃M', dans lesquelles R₂ et R₃ sont tels que définis pour les composés de formule (II) ci-dessus, et M, M' sont choisis parmi les métaux, dans un solvant aprotique polaire.

De préférence, dans cet autre procédé, le solvant aprotique polaire peut être choisi parmi les éthers comme le tétrahydrofurane (THF), le dioxane, les solvants halogénés, comme le chloroforme ou le dichlorométhane. Dans la formule R₂M et/ou la formule R₃M', le métal M ou M' est avantageusement le lithium, Li. Un catalyseur AX du type sel d'halogénure (avec la même définition que ci-dessus) tel que KI peut avantageusement être employé, mais sa présence n'est pas impérative.

Ces deux procédés présentent, par rapport aux procédés connus de l'art antérieur qui pourraient être appliqués aux molécules utilisés dans l'invention, l'avantage d'être très simples et de présenter de bons rendements, et donc d'être facilement industrialisables.

L'objet de l'invention est le procédé de dépôt d'un film de platine ou de particules de platine sur un support, ce procédé comprenant au moins une étape de dépôt chimique en phase vapeur de platine à partir d'au moins un précurseur tel que défini ci-dessus et notamment à partir d'un composé de formule (II) sur un support.

Le dépôt chimique en phase vapeur comprend au moins deux étapes : une première étape de mise en phase vapeur du précurseur, dans des conditions qui n'affectent pas sa stabilité, et une seconde étape de décomposition du précurseur en platine sur un support.

On peut effectuer la mise en phase vapeur du composé précurseur pur, qu'il soit liquide ou solide à température ambiante, ou du composé précurseur en solution dans un solvant.

Parmi les solvants utilisables pour la mise en oeuvre du procédé de l'invention, on préfère les composés organiques, qui sont liquides à température ambiante et jusqu'à environ 200° C dans les conditions normales de pression, qui ne réagissent ni avec le précurseur ni avec le support, et qui sont résistants à l'oxydation. A titre d'exemple, on peut citer les solvants hydrocarbonés cycliques tels que par exemple le cyclohexane ou le tétrahydrofuranne et les solvants aromatiques tels que le mésitylène, le xylène, le toluène ou encore le n-octane.

Lorsque le précurseur est utilisé sous forme d'une solution dans un liquide organique, la concentration en précurseur de la solution est avantageusement supérieure ou égale à 10⁻³ mol/1. Lorsque l'on utilise une solution très diluée de précurseur, on favorise la formation d'un dépôt discontinu de particules de platine, tandis que des concentrations élevées favorisent la formation d'un film continu. La dilution de la solution de précurseur influe aussi sur la taille des cristallites formées.

Lors de la mise en oeuvre du procédé de dépôt de couches de platine sur un support, la composition contenant le précurseur tel que (II) est envoyée dans un dispositif de vaporisation par l'intermédiaire duquel elle est introduite dans une enceinte de dépôt à température élevée qui contient le support sur lequel la couche de platine doit être déposée. Par exemple on fait buller un gaz dans le réservoir contenant le composé précurseur tel que (II) et ce gaz entraîne le composé précurseur en phase vapeur.

De façon habituelle, avant son arrivée dans le dispositif de vaporisation, la composition est maintenue dans un réservoir à température ambiante. La vaporisation de la composition de précurseur tel que (II) peut être effectuée à l'aide de divers dispositifs connus de l'homme de métier. Par exemple, on peut citer le dispositif décrit dans T. Y. Chen et al., Chem. Mat. 2001, 13, 3993, commercialisé par la société Jipelec sous le nom de "InJect Système d'injection et d'évaporation de précurseurs liquides purs ou sous forme de solutions".

Lorsque le composé précurseur est liquide ou qu'il est mis en solution, on peut utiliser pour son introduction dans l'enceinte de dépôt le procédé d'injection liquide d'organométalliques par CVD (DLI-MOCVD) tel que décrit dans WO2007/088292. Le principe de la DLI-MOCVD est issu des systèmes classiques de CVD. Les espèces réactives sont apportées sous forme liquide et sont injectées à haute pression par des injecteurs. Ce procédé permet de contrôler la morphologie des particules en fonction des paramètres d'élaboration (la masse de produit injecté, la fréquence d'injection, le solvant du précurseur et le temps de dépôt) et permet une mise en oeuvre facile à l'échelle industrielle.

Le composé précurseur est ainsi, par l'une quelconque des méthodes citées ci-dessus, introduit dans l'enceinte de dépôt. Dans cette enceinte se trouve le support ou substrat sur lequel doit se faire le dépôt. Le composé précurseur est alors soumis à une décomposition qui entraîne son dépôt sur le support.

Le substrat sur lequel la couche de platine est déposée peut être un matériau supraconducteur à haute Tc (température critique), une céramique, notamment une céramique dense ou une céramique poreuse, un polymère thermorésistant, un verre, MgO, un perovskite tel que LaAlO₃, Ni, Si, AsGa, InP, SiC et SiGe. La couche de platine peut être déposée sur ledit support comme première couche ou comme x^{ième} couche de métallisation pour les dispositifs électroniques nécessitant plusieurs niveaux de métallisation, x étant un entier supérieur ou égal à 2. Le support peut être constitué par l'un des matériaux précités pris tel quel, ou bien par l'un de ces matériaux portant une ou plusieurs couches intermédiaires. A titre d'exemple de couches intermédiaires, on peut citer les films métalliques (par exemple un film de Ni), une couche organique (par exemple une couche d'un matériau polymère), les couches de diffusion constituées par au moins un matériau choisi par exemple parmi TiN, TiSiN, Ta, TaN, TaSiN, WN, WSiN. Dans le cas du dépôt d'une dispersion, on choisit un support servant à la tenue mécanique et comprenant au moins une couche microporeuse conductrice électronique, également appelée couche de diffusion. Par exemple, le support est avantageusement choisi parmi les textiles comportant une couche superficielle microporeuse carbonée : le carbone poreux de la couche de diffusion sur laquelle est effectué le dépôt est réalisé par exemple en carbone, en graphite ou est constitué de nanotubes. Le carbone peut être de type Vulcan XC 72 ou de type Shawanagan.

Différentes conditions, dont l'activation du substrat, permettent de favoriser le dépôt sur le substrat par rapport à un dépôt sur les parois de l'enceinte.

Notamment, selon le procédé ALD (atomic layer deposition ou dépôt de couches atomiques), dans l'enceinte de dépôt est injecté un gaz réactif qui favorise la décomposition du précurseur.

On peut selon l'invention placer l'enceinte:
- sous atmosphère neutre à l'aide d'un gaz choisi par exemple parmi : N₂, Ar, He,
   ou
- sous atmosphère d'oxygène éventuellement en mélange avec un gaz neutre comme de l'azote (US2002/0000591 ; US6750110), l'oxygène ayant l'avantage de favoriser la combustion des matières organiques,
   ou
- sous atmosphère d'hydrogène (US5130172), qui favorise la décomposition et influence la taille et la forme des cristallites,
   ou
- sous atmosphère d'ozone,
et sous une pression préférentiellement comprise entre 10⁻³ et 1 000 mBar.

On peut utiliser l'un quelconque des procédés CVD connus de l'homme du métier pour activer le substrat et notamment : une activation thermique, un dépôt chimique en phase vapeur induit par laser (LCVD) (JP8020870), un dépôt chimique en phase vapeur induit par UV (US-6204178 ; US2006/0014367), un dépôt chimique en phase vapeur induit par plasma (PECVD), un dépôt chimique en phase vapeur assisté par faisceaux d'ions (IACVD) (US5104684), un dépôt chimique en phase vapeur induit par faisceau d'électrons (EBCVD), un dépôt chimique en phase vapeur en lit fluidisé (FBCVD). Ces méthodes sont décrites dans leur principe et avec des exemples de réalisation pratique dans C. Thurier et P. Doppelt, Coord. Chem. Rev. 252, (2008) 155-169.

Dans tous les cas, la température du substrat à revêtir est supérieure ou égale à la température de décomposition du précurseur. La température dans l'enceinte de dépôt est supérieure ou égale à la température de vaporisation du précurseur et inférieure ou égale à la température de décomposition du précurseur. Lorsque le dépôt est effectué en présence de plasma, il est suffisant que le support destiné à recevoir la couche de platine soit maintenu à la même température que l'évaporateur. En l'absence de plasma, il est préférable que le support soit à une température supérieure à celle de l'enceinte, la différence de température étant au moins égale à 20°C, de préférence au moins égale à 50°C, afin d'éviter le dépôt de platine sur les parois du réacteur.

Les températures de vaporisation et de décomposition du précurseur peuvent être facilement déterminées pour chaque composé ainsi qu'il sera montré dans la partie expérimentale.

On peut prévoir un dépôt séquentiel comportant au moins une étape qui favorise la nucléation et au moins une étape favorisant la croissance du film (US2002/0000591).

Plusieurs méthodes d'activation peuvent être combinées entre elles afin de mieux contrôler la qualité du dépôt.

L'épaisseur de la couche de platine qui se dépose sur le support dépend de la concentration de la composition de précurseur, tel que (II), du débit de cette composition lors du passage dans le dispositif de vaporisation, de la durée de la vaporisation, des températures respectives dans le réacteur et sur le support. De manière générale, on utilise des compositions moins concentrées et/ou des débits plus faibles pour l'obtention de particules isolées et des couches fines, et des compositions plus concentrées et/ou des débits plus élevés pour l'obtention de couches épaisses. Par couche fine, on entend généralement une couche ayant une épaisseur inférieure ou égale à 50 nm, dite couche de nucléation. Par couche épaisse, on entend généralement une couche ayant une épaisseur entre 50 nm et 10 µm.

Pour l'obtention de couches épaisses, l'on peut utiliser le produit pur ou les compositions dans un solvant à coefficient de dissolution élevée, à une concentration en précurseur proche de la saturation. La concentration doit rester inférieure à la valeur à saturation, afin d'éviter la reprécipitation du précurseur qui aurait pour effet de gêner la vaporisation.

Pour l'obtention de couches minces ou pour les dispersions de platine, on peut utiliser le produit pur ou les solvants dans lesquels la solubilité du précurseur est plus faible. On peut également utiliser un liquide organique qui ne soit pas un solvant du précurseur et qui soit chimiquement inerte vis-à-vis du précurseur pour diluer une composition de précurseur selon l'invention.

On peut également prévoir que le procédé de l'invention comporte l'utilisation d'un capteur permettant d'évaluer la quantité de gaz réactif (O₂, H₂O, N₂O, O₃...) à fournir pour décomposer les restes organiques du précurseur) adsorbés en surface lorsque le taux de déposition devient trop faible (US2003/0049932).

La mise en oeuvre du procédé de l'invention pour le dépôt de couches de platine par CVD permet d'obtenir des dépôts de bonne qualité ayant une bonne adhérence au substrat sur lequel elles sont déposées.

Ce procédé permet notamment de faire un dépôt sélectif de platine sur certaines zones du support tout en évitant de le déposer sur d'autres portions de ce même support (US2002/0090450).

En conclusion, les composés organométalliques utilisés dans l'invention permettent de fabriquer des films ou des dispersions de particules de platine ayant une bonne stabilité envers l'oxygène et l'humidité ainsi qu'une bonne stabilité au stockage à température ambiante, de préférence dans le noir. Leur température de décomposition est assez basse pour permettre le dépôt de films de platine dès 250°C grâce à un effet catalytique prononcé du platine formé. Les films obtenus ont une très bonne pureté.

Ainsi, les films obtenus grâce aux composés utilisés dans l'invention ont d'excellentes propriétés catalytiques.

L'invention a encore pour objet un procédé de production d'un composant électronique comportant au moins une étape de dépôt chimique en phase vapeur de platine à partir d'au moins un précurseur, (II), telle que décrite ci-dessus.

L'invention a encore pour objet un procédé de production d'un catalyseur solide à base de platine supporté comportant au moins une étape de dépôt chimique en phase vapeur de platine à partir d'au moins un précurseur (II), telle que décrite ci-dessus.

Le procédé de l'invention concerne plus particulièrement la production de piles à combustible. Dans ce cas on préfère un dépôt de platine sous forme de particules isolées.

### PARTIE EXPERIMENTALE :

- la figure 1 représente les courbes obtenues par analyse thermogravimétrique (ATG) des précurseurs de formule (II-A), (II-B) et (II-C) selon l'invention, en comparaison avec les précurseurs de l'art antérieur,
- la figure 2 représente le graphe d'Eyring des précurseurs de formules (II-A), (II-B) et (II-C), en comparaison avec celui des précurseurs de l'art antérieur,
- la figure 3 représente le spectre obtenu par spectroscopie des photoélectrons induits par rayons X (XPS) d'un film de platine obtenu en utilisant le composé de formule (II-A),
- la figure 4 représente le spectre obtenu par spectroscopie des photoélectrons induits par rayons X (XPS) d'un film de platine obtenu en utilisant le composé de formule (II-B),
- la figure 5 représente une photographie prise en microscopie électronique à balayage (MEB) d'un film obtenu en utilisant le composé de formule (II-A) et
- la figure 6 représente une photographie prise en microscopie électronique à balayage (MEB) d'un film de platine obtenu en utilisant le composé de formule (II-B)
- la figure 7 représente les courbes obtenues par analyse thermogravimétrique (ATG) comparative des précurseurs du platine II-E (Pt81), II-A (Pt54) et (MeCp)PtMe₃ (débit d'Ar : 10 sccm ; 10°C/min)

### Exemple 1 : Synthèse en une seule étape du composé de formule (II-B) : (Etnbd)PtMe₂.

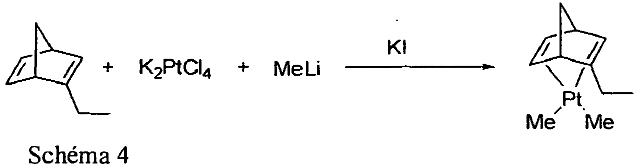

Dans un tube de Schlenk sec et sous argon, verser 830 mg de K₂PtCl₄, 20 mL de THF distillé sur sodium et benzophénone, 600 µL (510 mg) d'éthylnorbornandiène. A température ambiante, verser 7 mL de MeLi 1,6 M. Maintenir sous agitation vigoureuse pendant 24 h à température ambiante.

A 0°C, verser 30 mL d'éther diéthylique, puis une solution de 500 mg de NH₄Cl dans 20 mL d'eau distillée. Extraire et laver la phase organique avec 2 fois 20 mL d'eau. Sécher la phase éthérée avec MgSO₄ et ajouter une spatule de charbon actif. Filtrer, évaporer les solvants.
Masse obtenue : 574 mg (liquide brun à incolore).
Rendement : 83 %.
Caractérisation physico-chimique : 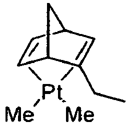 (Etnbd)PtMe₂ :
RMN¹H (400,132 MHz, CDCl₃):
   δ(ppm) : 5,12 (tt, 1H, 20Hz, 4Hz) ; 4,95 (tt, 1H, 19Hz, 4Hz) ; 4,69 (td, 1H, 20Hz, 3Hz) ; 3,94 (s, 1H); 3,81 (s, 1H); 2,22 (m, 2H) ; 1,59 (q, 2H, 6Hz) ; 1,13 (t, 3H, 6Hz); 0,73 (t, 3H, 44Hz) ; 0,65 (t, 3H, 44Hz)
RMN ¹³C (100,622 MHz, CDCl₃):
   δ(ppm) : 111,8 ; 88,4 ; 84,8 ; 73,1 ; 52,3 ; 50,0 ; 25,1 ; 12,6 ; 3,45.

### Exemple 2 : Synthèse du ligand éthyle norbornadiène du composé de formule (II-B).

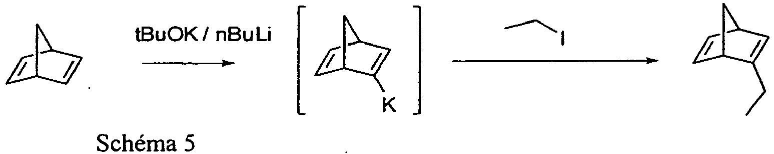

Dans un tricol sec sous argon de 250 mL, verser 100 mL de THF distillé sur sodium et benzophénone puis 7,2 g de tBuOK et 8 mL de norbornadiène. L'ajout du norbomadi ène conduit à la dissolution du tBuOK. Refroidir à -80°C et verser goutte-à-goutte 20 mL de *n*-BuLi 1,6 M en 30 minutes. Laisser revenir à -40 °C et maintenir à cette température 30 minutes. Revenir à -80 °C et verser goutte-à-goutte une solution aqueuse de NH₄Cl à O°C. Laisser revenir doucement à température ambiante et agiter une nuit.

Verser 100 mL d'eau et extraire avec 2 fois 100 mL d'éther diéthylénique. Laver la phase organique avec 2 fois 100 mL d'eau. Sécher avec MgSO₄. Filtrer, évaporer les solvants. Distiller sous pression légèrement réduite.
Masse obtenue : 2,4 g (liquide incolore)
Rendement : 62 %.
Caractérisation physico-chimique : 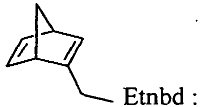
RMN ¹H (400,132 MHz, CDCl₃):
   δ(ppm) : 6,76 (s, 2H) ; 6,10 (s, 1H) ; 3,49 (s, 1H) ; 3,27 (s, 1 H) ; 2,20 (m, 2H) ; 1,96 (dd, 2H, 14Hz, 6Hz) ; 1,00 (t, 3H, 7,5Hz).
RMN ¹³C (100,622 MHz, CDCl₃) :
   δ(ppm) : 160,7 ; 144,0 ; 142,4 ; 132,2 ; 73,4 ; 68,0 ; 53,5 ; 50,0 ; 24,7 ; 11,8.

### Exemple 3 : Synthèse en deux étapes du composé de formule (II-A) : (nbd)PtMe2

### Etape 1 : Synthèse de (nbd)PtI₂

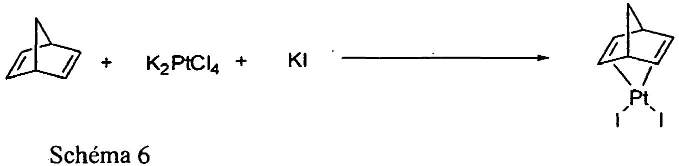

Dans un ballon, peser 20 g de K₂PtCl₄, ajouter 220 mL d'eau et agiter pour tout dissoudre. Ajouter 33 g de KI et agiter 15 minutes à température ambiante. Ajouter ensuite 225 mg de SnCl₂.2 H₂O, 120 mL d'isopropanol et 15 mL de norbornadiène. Agiter à température ambiante 40 heures. Concentrer le milieu en évaporant l'isopropanol à l'évaporateur rotatif sous vide. Filtrer sur fritté, laver à l'eau, puis au méthanol froid. Sécher sous vide plusieurs heures.
Masse : 26,6g rendement 99 %.

### Etape 2 : Synthèse de (nbd)PtMe₂

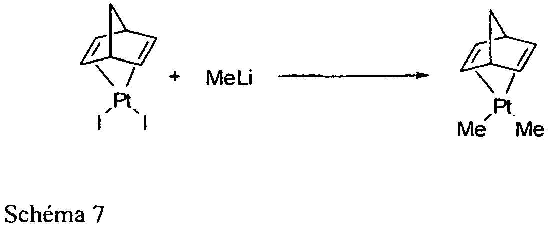

Dans un tricol de 250 mL, verser 10g de (nbd)PtI₂ puis 140 mL d'Et₂O distillé. A -80 °C (bain d'acétone glacée), ajouter 25 mL de MeLi 1,6 M goutte-à-goutte. Laisser le bain se réchauffer doucement jusqu'à -20°C (en 3 heures environ) puis enlever le bain d'acétone pendant une heure.

Préparer une solution glacée aqueuse de NH₄Cl (20g dans 200 mL d'eau) dans un grand bécher et verser le milieu réactionnel dedans. Décanter et laver la phase organique avec 2 fois 150 mL d'eau. Sécher sur MgSO₄, ajouter une spatule de noir animal, agiter, filtrer, évaporer les solvants. On obtient un solide jaune très pâle.

Le produit peut encore être purifié par chromatographie sur colonne d'alumine en éluant avec un mélange éther/pentane (1 : 1). Une étape de sublimation conduit également à une excellente pureté.
Masse : 5,757g rendement : 98 %.
Caractérisation physico-chimique : 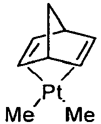 (nbd)PtMe₂ :
RMN ¹H (400,132 MHz, CDCl₃):
δ(ppm): 5,00 (t, 4H, 20 Hz) ; 3,96 (s, 2H) ; 1,55 (s, 2H) ; 1,50 (s, 2H) ; 0,67 (t, 6H, 44Hz)
RMN ¹³C (100,622 MHz, CDCl₃) :
δ(ppm) : 87,3 (t, 23Hz) ; 71,8 (t, 22Hz) ; 48,1 (t, 20Hz) ; 4,0 (t, 406Hz).

### Exemple 4 : Synthèse des composés de formule (II-E) et (II-F) : (7-Me-nbd)PtMe₂ et (7-Et-nbd)PtMe₂

### - Produits de départ pour la synthèse des 7-norbornadiènes substitués.

Les ligands (7-Me-nbd) et (7-Et-nbd) peuvent être synthétisés selon une méthode préalablement décrite (P. R. Story, S. R. Fahrenholtz, Journal of Organic Chemistry, 1963, 28, 1716-1717).

Le 1,2-bis(p-tolylsulfonyl)éthène et le 1,2- bis(p-tolylmercapto)éthène utilisés comme produits de départ ont été synthétisés selon une méthode préalablement décrite (W. E. Truce, R. J. McManimie, J. Am. Chem. Soc., 1954, 76, 5745-5747).

### - Préparation des nouveaux 7-norbornadiènes substitués:

Les 7-norbornadiènes substitués ont été synthétisés en deux étapes : (i) la réaction de Diels-Aldel de cyclopentadiènes substitués sur le 1,2-bis(p-tolylsulfonyl)éthène et (ii) l'élimination réductrice de l'espèce anionique TolylSO2- par l'amalgame Na-Hg en milieu basique.

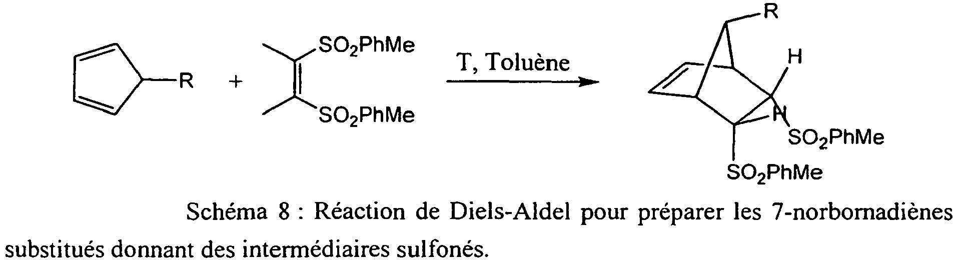

### - Produit sulfonés intermédiaires préparés à partir du méthylcyclopentadiène (MeCp)

Dans un tricol de 100 mL, on charge 0,5 g de di-p-toluène sulfonyl éthylène (1,5 mmol) et 20 mL dé toluène. Dans cette solution chauffée à reflux, on ajoute goutte à goutte une solution de 3,0 g (37 mmol) de méthylcyclopentadiène fraîchement craqué par distillation à partir du dimère (MeCp)2 dans 10 mL toluène. Ce mélange réactionnel est agité à reflux pendant 10 min et à température ambiante pendant 3 h. Le produit solide incolore (0.45 g) qui a précipité est récupéré par filtration.
Rendement = 72,5% (basé sur le di-p-toluène sulfonyl éthylène).
Point de fusion = 248-250°C.
(TLC : solvant CH2Cl2/MeCOOEt = 9/1 : Rf= 0.68)
RMN 1H (400,132 MHz, CDCl3) : δ(ppm) 7,82 (m, CH du Ph), 7,31 (m, CH du Ph), 6,35 (CH=), 3,17 (CH du Cp), 2,43 (CH3 du Ph), 2,15 (CH du Cp), 2,91 (CH-SO2Ts), 1,23 (CH3 du Cp).

### - Produits sùlfonés intermédiaires préparés à partir de l'éthylcyclopentadiène (EtCp)

Les conditions réactionnelles sont similaires à celles utilisés quand le MeCp est le produit de départ ci-dessus sauf le temps d'agitation à température ambiante qui est de 4 heures au lieu de 3.
Le produit obtenu est un solide blanc; Rendement = 46,5 %.
Point de fusion : 216-220°C
RMN 1H (400,132 MHz, CDCl₃): δ(ppm) 7,88 (CH du Ph), 7,31 (CH du Ph), 6,02 (CH=), 2,94 (CH du Cp), 2.49 (CH3 du Ph), 2,0-1,8 (CH du Cp), 1,12 (t, J=7,5 Hz, CH3 du Et), 0.77 (t, 7,5 Hz, CH2 du Et).

### - Réaction d'élimination du p-tolylsulfonyl

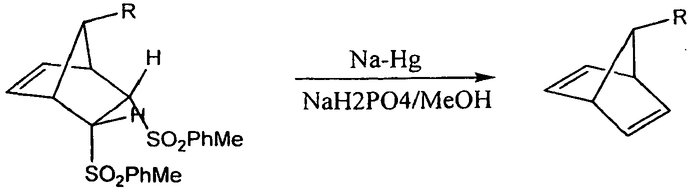

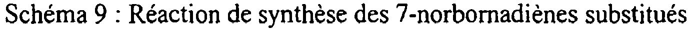

Dans un ballon de 250 mL, on charge 3 mmol d'un des produits précédemment synthétisés (produits issus de la réaction de Diels-Alder), 6.0 g du NaH2PO4 dans 80 mL de MeOH. Ce mélange est placé sous Argon et agité. Ensuite, après addition de 10 g d'amalgame Na-Hg (5% Na), la suspension est agitée 18h à la température ambiante sous Ar. L'amalgame est éliminé par décantation. On obtient alors une solution incolore contenant un précipité blanc à laquelle 100 mL d'eau permutée sont ajoutés. La suspension est alors filtrée. Dans le filtrat, on ajoute alors 40 mL d'une solution saturée en NaCl et le nouveau précipité formé est éliminé par filtration. Le filtrat est ensuite extrait par 3 fois 50 mL de pentane. La phase organique obtenue est lavée 3 fois par une solution aqueuse saturée en NaCl (30 mL), séchée ensuite par MgSO4 et puis filtrée. Le pentane est éliminé ensuite à l'évaporateur rotatif et on récupère le produit liquide incolore attendu.

### - Caractérisation :

*7-méthyl-bicyclo[2.2.1] heptane-2,5-diene (Me-nbd)*
+ Rendement = 37,5%
+ GC-MS : Temps de rétention = 1.14 min.; m/z = 105, 91, 79, 65, 51
+ RMN 1H (400,132 MHz, CDCl₃): δ(ppm) 5,54 (t, J=4 Hz, 4xCH=), 3,10 (s, 2x-CH), 2,15 (m, 1x-CH), 1,21 (s, 1x-CH3).
*7-Ethyl- bicyclo[2.2.1] heptane-2,5-diene (Et-nbd)*
+ Rendement = 35%
+ RMN 1H (400,132 MHz, CDCl3): δ(ppm) 5,13 (4x CH=), 2,94 (2x CH), 2,0 (1x CH pont), 1,13 (1x CH3 ethyl) et 0,78 (1x CH2 ethyl).

### - Synthèses des précurseurs du platine (II-E) et (II-F)

Les composés **(II-E)** et **(II-F)** ont été synthétisés selon le protocole décrit ci-dessus dans l'exemple 3.
**(7-Me-nbd)PtI₂**
Rendement = 60,2%.
Produit solide jaune avec un point de fusion de 128-130°C
RMN ¹H (400,132 MHz, CDCl₃): δ (ppm) 5,66 (t, J=4 Hz, 4xCH=), 3,10 (s, 2x-CH), 2,15 (m, 1x-CH), 1,21 (s, 1x-CH₃)
**(7-Et-nbd)PtI₂**
Rendement = 70,5%.
Produit solide jaune avec un point de fusion de 140-142°C.
RMN ¹H (400,132 MHz, CDCl₃): δ(ppm) 5,35 (4x CH=), 2,97 (2x CH), 2,08 (1x CH du pont), 1,15 (1x CH₃ ethyl) et 0,70 (1x CH₂ ethyl).
**(7-Me-nbd-)PtMe2 (II-E)**
Rendement = 60%
Liquide jaune avec un point de fusion voisin de -15°C.
RMN ¹H (400,132 MHz, CDCl₃): δ (ppm) 5,08 (t, J=4 Hz, 4x CH=), 3,10 (s, 2x-CH-), 2,05 (m, 1x-CH-), 1,21 (s, 1x-CH₃ du *nbd-Me),* et 0.717 (s, 2x-CH₃) ppm
**(7-Et-nbd)PtMe₂ (II-F)**
Liquide jaune avec un point de fusion voisin de -15°C.

### Exemple 5 : Caractérisation physico-chimique du composé de formule (II-C) : (TMSnbd)PtMe₂

Le composé (II-C) a été préparé conformément au protocole de l'exemple 1. 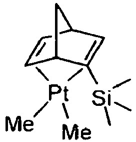
(TMSnbd)PtMe₂:
RMN ¹H (400,132 MHz, CDCl₃) :
δ(ppm) : 5,11 (td, 1H, 21Hz, 4Hz) ; 4,90 (tt, 1H, 22Hz, 4Hz) ; 4,68 (tt, 1H, 20Hz, 4Hz) ; 3,72 (s, 1H); 3,58 (s, 1H); 1,50 (dd, 2H, 53Hz, 9Hz) ; 0,59 (t, 3H, 46Hz) ; 0,53 (t, 3H, 46Hz) ; 0,01 (s, 9H)
RMN ¹³C (100,622 MHz, CDCl₃):
δ (ppm): 154,6 (s); 144,57 (s); 143,7 (s); 101,3 (t, 20Hz) ; 99,4 (t, 24Hz) ; 91,3 (t, 25Hz) ; 87,4 (25Hz) ; 74,8 (t, 25Hz) ; 53,8 (t, 25Hz) ; 51,6 (t, 25Hz) ; 7,3 (td, 409Hz, 163Hz) ; 0 (s).

### Exemple 6 : Etude par ATG des composés de l'invention permettant de déduire des informations sur leur volatilité et leur stabilité.

### - Principe :

Les études ATG ont été entreprises sur les composés organométalliques de l'invention et comparés à celles des produits de la littérature.

Toutes les expériences ont été réalisées sous argon avec une rampe de montée en température de 10°C par minute.

La perte de masse observée est attribuée conjointement à la volatilisation du précurseur et à la décomposition (partielle ou totale) du précurseur suivie de l'évaporation rapide des résidus organiques.

On peut estimer que lors d'une décomposition totale du précurseur, c'est-à-dire avec élimination de tous les ligands et substituants organiques, ceux-ci sont volatilisés instantanément du fait de leur bonne volatilité. La perte de masse observée est donc liée directement à la cinétique de décomposition. Lors d'une décomposition partielle, du carbone non volatil provenant des restes de ligands peut subsister dans la masse de platine. Une partie de la perte de masse peut être liée à une évaporation du précurseur sans décomposition.

### - Résultats :

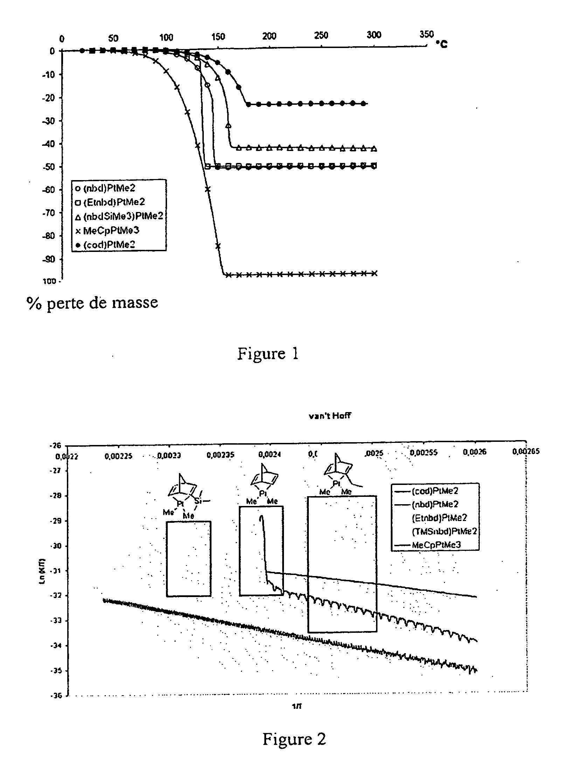

Les courbes obtenues sont représentées dans la figure 1.

Comme on le voit dans la figure 1, parmi les composés organométalliques de l'invention, le composé de l'art antérieur MeCpPtMe₃ possède le comportement le plus spécifique : en augmentant la température, la masse décroît de manière quasi-exponentielle pour atteindre 2 % de la masse initiale à 160°C. Ceci démontre la très bonne volatilité de ce précurseur mais aussi le fait que sa décomposition est négligeable jusqu'à cette température.

En comparaison, la masse du composé organométallique de platine de l'art antérieur (cod)PtMe₂ décroît jusqu'à 76 % de la masse initiale. Cette valeur reste largement au-dessus de la masse de platine initiale contenue dans le précurseur, qui est de 58 %. Le précurseur de l'art antérieur (cod)PtMe₂ n'est donc pas très volatil et le solide résiduel contient au minimum 24 % de carbone.

Par comparaison, les composés organométalliques utilisés dans l'invention se décomposent à des températures modérées et sans production de résidus carbonés.

En effet, on observe sur la figure 1 que la masse du composé de formule (II-A) de l'invention décroît jusqu'à 52 %, sous la masse théorique de platine qui est de 61 %. Ceci démontre une bonne volatilité de ce précurseur dont au moins 18 % s'est évaporé et indique une faible teneur en carbone.

Quant au composé de formule (II-B), les résultats sont assez similaires à ceux obtenus avec le composé de formule (II-A), avec une masse finale de 51 % contre 56 % pour la masse de platine théorique, soit au moins 9 % de précurseur évaporé.

Quant au composé de formule (II-C), sa masse en fin d'expérience est de 57 %. Elle demeure au-delà de la masse initiale de platine, qui est de 50%, ce qui démontre l'incorporation de carbone et de silicium dans le résidu.

### Exemple 7 : Etude de la stabilité des composés (II-A) et (II-B)

De manière surprenante, l'analyse thermogravimétrique a révélé que le composé organométallique de formule (II-A), était non seulement le plus stable à température ambiante, mais également à une température de décomposition (qui correspond à la température à laquelle la décomposition est la plus rapide) plus basse que les composés de l'art antérieur.

Mais tous les composés organométalliques utilisés dans l'invention présentent un profil cinétique de décomposition complexe où il a été mis en évidence deux processus distincts qui apparaissent nettement lorsque l'on trace les courbes d'Eyring-Polanyi. Ces courbes sont représentées dans la figure 2. Comme on le voit dans la figure 2, on observe une chute de la masse brutale vers 140 °C particulièrement pour (nbd)PtMe₂ et (Etnbd)PtMe₂.

Dans le cas d'une cinétique d'ordre 0, des droites doivent être obtenues en traçant Ln(k/T) en fonction de 1/T puisque l'on a :

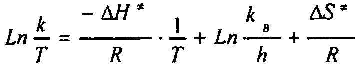

Dans le cas d'une perte de masse par processus d'évaporation du précurseur, la cinétique de la perte de masse doit suivre une tendance proche, l'expression de la tension d'un corps pur étant reliée d'une manière similaire à l'exponentielle de la température. Une expression couramment utilisée de la tension de vapeur pour un corps pur est par exemple :

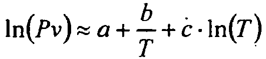

La composante d'évaporation du précurseur dans la perte de masse observée ne devrait donc que peu affecter l'aspect général des courbes.

La courbe d'Eyring-Polanyi obtenue avec le composé de l'art antérieur MeCpPtMe₃ -qui s'évapore sans se décomposer- suit une tendance quasi-linéaire, ce qui valide l'approximation précédente.

Si ce tracé conduit bien à une droite dans le cas du précurseur de l'art antérieur (cod)PtMe₂, les graphes obtenus avec les précurseurs de l'invention présentent eux deux parties distinctes : une droite pour les basses températures puis un saut correspondant à une brutale augmentation de la vitesse au-delà d'une température de transition. L'existence de ces deux processus démontre un changement de mécanisme lié à l'apparition d'une nouvelle espèce. Une explication serait que le platine solide formé sert alors de catalyseur à la décomposition des précurseurs de l'invention. La forme « bosselée » des courbes suggère également un processus hétérogène.

Le fait important est que cette décomposition « catalytique » n'est pas observée avec les autres précurseurs de l'art antérieur, ce qui implique des propriétés particulières du platine formé avec les précurseurs de l'invention : pureté, taille des cristaux et/ou un effet d'inhibition observé par exemple avec le ligand cod mais pas avec les ligands (I) de l'invention.

### Exemple 8 : Dépôts chimiques en phase vapeur de platine à partir des composés de formule (II-A) et (II-B), selon l'invention

Les dépôts de platine ont été mis en oeuvre en utilisant un appareil de dépôt chimique en phase vapeur de laboratoire équipé d'un système de vaporisation à partir de la phase liquide commercialisé par la société Jipelec sous le nom de "InJect Système d'injection et d'évaporation de précurseurs liquides purs ou sous forme de solutions". Les échantillons ont été chauffés sur un support SiO₂/Si (silicium monocristallin de taille 1x1 cm² recouvert de 100 nm de SiO₂) au milieu d'une jarre en verre à cloche placé dans une étuve. Une ligne d'évacuation a été connectée à un piège à oxygène et à une pompe. La jarre à cloche a été surmontée d'une chambre d'évaporation préchauffée à laquelle deux entrées de gaz et un injecteur de liquide pressurisé ont été connectés. Le toluène a été choisi en tant que solvant pour fabriquer des solutions 0,1M des précurseurs, qui ont été vaporisés à une vitesse de 0,67 mL.min⁻¹. La pression a été maintenue à 1 mbar. Les deux entrées de gaz délivraient respectivement 40 sccm N₂ et 15 sccm O₂. Les températures ont été fixées à 80°C pour la chambre d'évaporation et à 100°C pour l'étuve. La vitesse de dépôt dépend de la température de sorte qu'une température du substrat de 300°C a été préférée pour obtenir des dépôts avec une épaisseur appropriée.

### Exemple 9 : Etude des vitesses de dépôt

Le phénomène observé à l'exemple 6 est confirmé par les vitesses de dépôt obtenues avec les précurseurs de l'invention (nbd)PtMe₂ et (Etnbd)PtMe₂ qui sont dans des conditions identiques nettement supérieures à celles observées avec le (cod)PtMe₂.

Afin de vérifier si la différence de réactivité entre le (cod)PtMe₂ et le (nbd)PtMe₂ provenait d'un effet d'inhibition marqué dû à une interaction forte du ligand libéré au cours de la décomposition du précurseur avec le platine solide formé, les vitesses de dépôt obtenues avec des solutions de :
- précurseur (cod)PtMe₂ (art antérieur),
- précurseur (nbd)PtMe₂ (composé de formule (II-A) de l'invention),
- précurseur (nbd)PtMe₂ + 5 équivalents de ligand cod libre
- précurseur (nbd)PtMe₂ + 5 équivalents de ligand nbd libre,
ont été comparées.

Dans des conditions de dépôt identiques, c'est à dire en utilisant 20 mL de solution 0,1 M dans le toluène, vaporisée en 30 minutes avec un vaporisateur à 80 °C, un four à 100°C, et des échantillons à 300 °C. On a également utilisé un gaz vecteur qui est un mélange de : N₂ 40 sccm, O₂ 15 sccm. La pression totale était d'environ 5 mbar, les vitesses obtenues sont de :
- précurseur (cod)PtMe₂ : 0,3 nm.min⁻¹
- précurseur (nbd)PtMe₂ : 2,0 nm.min⁻¹
- précurseur (nbd)PtMe₂ + 5 équivalents de ligand cod libre : 0,83 nm.min⁻¹
- précurseur (nbd)PtMe₂ + 5 équivalents de ligand nbd libre : 0,83 nm.min⁻¹

Ces résultats montrent que l'ajout de ligand libre a un effet d'inhibition sur la croissance du film. Ils démontrent également que cette influence du ligand libre est identique dans le cas du cod libre et du nbd libre. La différence de réactivité ne peut donc pas être attribuée à l'interaction du ligand libre avec le platine solide.

La différence de réactivité est donc très probablement liée à des propriétés des cristallites de platine formées, comme leur grande pureté.

Exemple 10 : Caractérisation par microscopie électronique à balayage et analyse par spectroscopie des photoélectrons induits par rayons X.

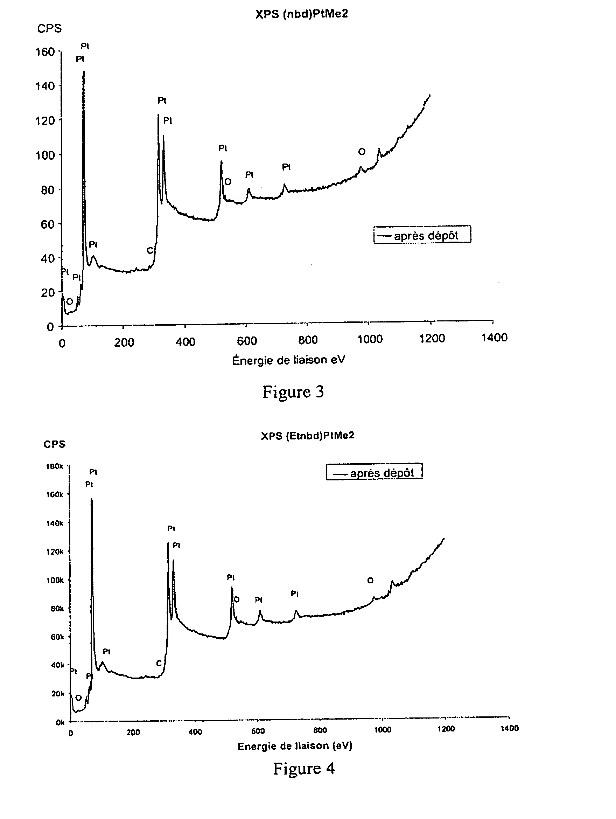

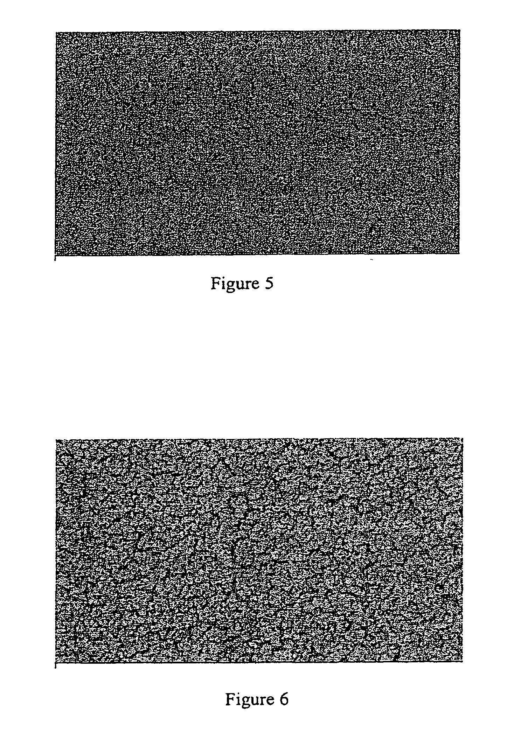

On constate à partir des figures 3 et 4 que les films de platine obtenus sont très purs et à partir des figures 5 et 6 qu'ils sont très homogènes.

La bonne pureté des films obtenus a été mise en évidence par des mesures XPS des films obtenus qui démontrent une très faible teneur en carbone.

Le spectre obtenu avec le composé de formule (II-A) est représenté sur la figure 3 et le spectre obtenu avec le composé de formule (II-B) est représenté sur la figure 4.

Une analyse de la surface par rayons X rasants a également démontré que les films étaient composés de petits cristallites de 6-7 nm de diamètre.

Ces résultats montrent que les composés ou précurseurs utilisés dans l'invention ont une bonne stabilité envers l'oxygène et l'humidité. Leur stabilité thermique dépend elle de l'encombrement stérique autour du métal. La température de décomposition est assez basse pour déposer des films dès 250 °C grâce à un effet catalytique prononcé du platine formé.

De façon importante, les films obtenus ont une très bonne pureté avec une faible incorporation de carbone dans les films formés. En effet, les données obtenues par spectroscopie des photoélectrons induits par rayons X du film de platine obtenu en utilisant le composé de formule (II-A), et du film de platine obtenu en utilisant le composé de formule (II-B), qui sont représentés respectivement en figures 3 et 4 révèlent que les films contiennent de l'oxygène mais pratiquement pas de carbone.

Les films de platine sont très purs et contiennent une petite quantité d'oxygène lié, probablement sous la forme PtO₂. En effet, les énergies observées pour les pics de O₂ sont différentes à la surface et dans la masse. Le carbone est présent seulement à la surface, probablement en raison de l'exposition à l'air.

Les films obtenus sont également très homogènes, comme on le voit en figure 5 et 6.

La figure 5 qui représente une photographie prise par microscopie électronique à balayage d'un film de platine obtenu en utilisant le composé de formule (II-A) en tant que précurseur, montre que le film obtenu, qui a ici une épaisseur de 60 nanomètres, est lisse et continu.

La figure 6 qui représente une photographie microscopique électronique à balayage du film obtenu en utilisant le composé de formule (II-B) en tant que précurseur, montre que le film obtenu, qui a ici une épaisseur de 80 nanomètres, est également lisse et continu, bien que moins lisse et moins continu que le film obtenu avec le composé de formule (II-A).

### Exemple 11 : Comparaisons entre II-A et II-D

### - Stabilité à l'air :

Le précurseur **II-E,** liquide jaune à la température ambiante, est plus stable à l'air que **II-A** car il peut être conservé une semaine à l'air à la température ambiante sans décomposition.

### - Stabilité thermique :

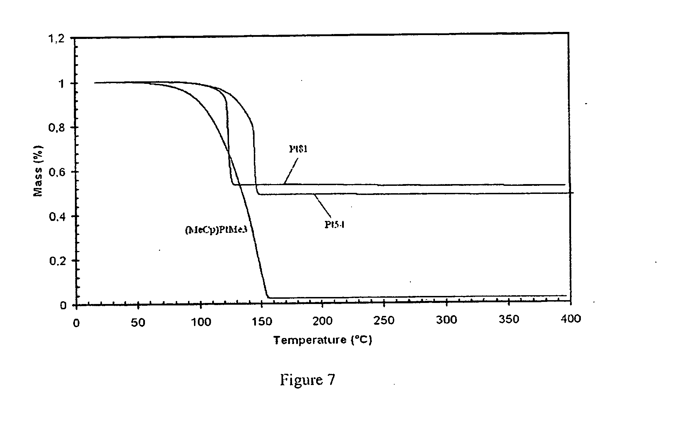

Dans l'analyse thermogravimétrique illustrée par la figure 7 (débit d'argon de 10 sccm, 10°C/min), une décomposition du précurseur **II-E** est observée à partir de ∼120°C avec formation de platine sous forme d'une poudre noir au lieu de ∼145°C pour **II-A** et ∼155°C pour (MeCp)PtMe₃. L'abaissement de la température de décomposition du précurseur peut se révéler importante pour certaines applications pour des dépôts sur des supports thermiquement sensibles.

### - Volatilité

**Table 1 : Températures auxquelles 5%, 10% et 50% de masse d'un précurseur est évaporé**

| **Précurseurs (°C)** | **T_{5%} (°C)** | **T_{10%} (°C)** | **T_{50%} (°C)** |
|---|---|---|---|
| (MeCp)PtMe₃ | 91 | 101 | 135 |
| **II-A** | 122 | 133 | *Décomposition* |
| **II-E** | 120 | 122,5 | *Décomposition* |

Le tableau 1 ci-dessus donne les températures auxquelles 5%, 10% et 50% en masse du précurseur est évaporé pour les trois précurseurs différents : le (MeCp)PtMe3, le II-A et le 11-E. Les T5% et T10% du (MeCp)PtMe3 sont nettement inférieures à celles du II-A et II-E. Ceci montre que (MeCp)PtMe3 est beaucoup plus volatil que les deux précurseurs de la famille norbornadiène. Pour ces derniers, le II-E semble être plus volatil que le **II-A** car la T_{5%} est similaire pour ces deux précurseurs mais la T_{10%} du **II-E** est inférieure à celle du **II-A.**

Le **II-E** est donc très prometteur comme précurseur pour le dépôt MOCVD du platine. Ce précurseur, liquide à la température ambiante, est très stable à l'air et volatil. De plus, il est plus « sensible » thermiquement que **II-A** et que le précurseur commercial (MeCp)PtMe₃. Par conséquent, on peut espérer obtenir à partir de ce précurseur des dépôts du platine à des températures plus basses.

## Revendications

1. Procédé de dépôt d'un film de platine ou de particules de platine sur un support, ce procédé comprenant au moins une étape de dépôt chimique en phase vapeur de platine sur un support à partir d'au moins un composé organométallique de platine **caractérisé en ce que** :
- le composé organométallique de platine répond à la formule (II) suivante : 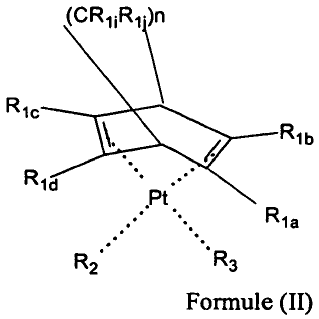 dans laquelle :
- n représente un entier choisi parmi 1 et 2,
- lorsque n=1, R₁ᵢ, R₁ⱼ représentent chacun un seul groupement, lorsque n=2, R₁ᵢ, R₁ⱼ représentent chacun deux groupements identiques ou différents,
- R₁ₐ, R_{1b}, R_{1c}, R_{1d}, R₁ᵢ, R_{1j,} identiques ou différents, sont choisis parmi : H, un atome d'halogène, un groupe alkyle en C₁ à C₄, un groupe trialkyl silane en C₁-C₄, un groupe alcényle en C₂ à C₄, un groupe alkyle en C₁ à C₄ porteur d'une ou plusieurs fonctions OH,
R₂ et R₃ sont choisis chacun indépendamment l'un de l'autre parmi les alkyles linéaires en C₁ à C₄
et
- le composé organométallique de platine a une structure plan-carré dans laquelle le platine est lié à chacune des doubles liaisons C=C du ligand en formant un angle (C=C)-Pt-(C=C) compris entre 60 et 70°.

2. Procédé selon 1a revendication 1 dans lequel l'angle (C=C)-Pt-(C=C) est compris entre 64 et 66° et avantageusement égal à 65°.

3. Procédé selon la revendication 1 ou la revendication 2 dans lequel l'une ou plusieurs des conditions suivantes est vérifiée :
- n = 1,
- R_{1b}, R_{1c}, R_{1d}, R₁ⱼ sont tous identiques et représentent H,
- R₁ₐ est choisi parmi : H, Cl, le méthyle, l'éthyle, le n-propyle, l'isopropyle, le tertiobutyle, le triméthylsilane, le propèn-3-yle, l'éthanol,
- R₁ᵢ est choisi parmi : H, le méthyle, l'éthyle.

4. Procédé selon la revendication 2 ou la revendication 3, dans lequel R₂ et R₃ sont identiques et sont choisis parmi : le méthyle, l'éthyle.

5. Procédé selon l'une quelconque des revendications précédentes, dans lequel le composé organométallique de platine est choisi parmi la liste suivante :

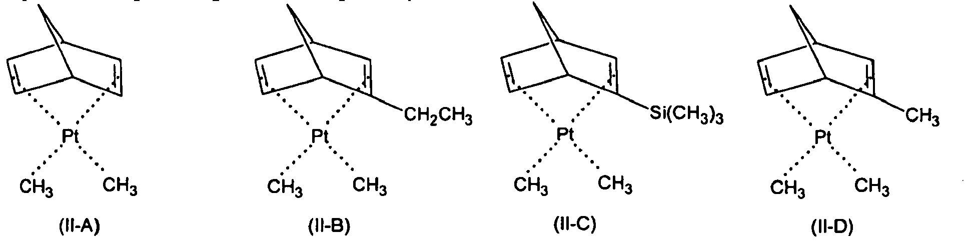

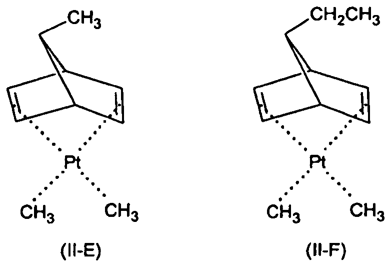

6. Procédé selon l'une quelconque des revendications 1 à 5 dans lequel le support sur lequel le dépôt d'un film de platine ou de particules de platine est effectué est choisi parmi : un matériau supraconducteur à haute Tc, une céramique, un polymère thermorésistant, un verre, MgO, un pérovskite tel que LaAlO₃, Ni, Si, AsGa, InP, SiC, SiGe, un textile comportant une couche superficielle microporeuse carbonée.

7. Procédé selon l'une quelconque des revendications 1 à 6, dans lequel le support sur lequel le dépôt d'un film de platine ou de particules de platine est effectué comporte une ou plusieurs couches intermédiaires choisies parmi : les films métalliques, une couche organique, les couches de diffusion constituées par au moins un matériau choisi par exemple parmi TiN, TiSiN, Ta, TaN, TaSiN, WN, WSiN, du carbone, du graphite, des nanotubes.

8. Procédé selon l'une quelconque des revendications 1 à 7, dans lequel le support est placé dans une enceinte :
- sous atmosphère neutre,
ou
- sous atmosphère d'oxygène éventuellement en mélange avec un gaz neutre,
ou
- sous atmosphère d'hydrogène,
ou
- sous atmosphère d'ozone.

9. Procédé selon l'une quelconque des revendications 1 à 8, dans lequel le support est soumis à au moins une activation choisie parmi : une activation thermique, une activation par laser, une activation par UV, une activation par plasma, une activation par faisceaux d'ions, une activation par faisceau d'électrons.

10. Procédé de production d'un composant électronique comportant au moins une étape de dépôt chimique en phase vapeur de platine selon l'une quelconque des revendications 1 à 9.

11. Procédé de production d'un catalyseur solide à base de platine supporté comportant au moins une étape de dépôt chimique en phase vapeur de platine selon l'une quelconque des revendications 1 à 9.

12. Procédé de production de piles à combustible comportant au moins une étape de dépôt chimique en phase vapeur de platine selon l'une quelconque des revendications 1 à 9.

## Patentansprüche

1. Verfahren zum Abscheiden eines Platinfilms oder von Platinpartikeln auf einem Träger, wobei das Verfahren wenigstens einen Schritt der chemischen Gasphasenabscheidung von Platin aus wenigstens einer metallorganischen Platinverbindung auf einem Träger umfasst, **dadurch gekennzeichnet, dass**:
- die metallorganische Platinverbindung die folgende Formel (II) hat: 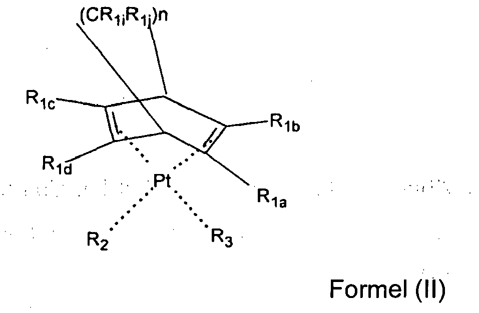 worin:
- n eine ganze Zahl ist, ausgewählt aus 1 und 2,
- wenn n = 1, R₁ᵢ und R₁ⱼ jeweils nur eine Gruppe darstellen, und wenn n = 2, R₁ᵢ und R₁ⱼ jeweils zwei gleiche oder verschiedene Gruppen darstellen,
- R₁ₐ, R_{1b}, R_{1c}, R_{1d}, R₁ᵢ und R₁ⱼ, die gleich oder verschieden sein können, ausgewählt sind aus: H, einem Halogenatom, einer C₁-C₄-Alkylgruppe, einer C₁-C₄-Trialkylsilangruppe, einer C₂-C₄-Alkenylgruppe und einer C₁-C₄-Alkylgruppe mit ein oder mehreren OH-Funktionen,
- R₂ und R₃ jeweils unabhängig voneinander ausgewählt sind aus linearen C₁-C₄-Alkylen, und
- die metallorganische Platinverbindung eine planquadratische Struktur aufweist, in der das Platin an jede der C=C-Doppelbindungen des Liganden unter Bildung eines (C=C)-Pt-(C=C)-Winkels zwischen 60 und 70° gebunden ist.

2. Verfahren nach Anspruch 1, wobei der (C=C)-Pt-(C=C)-Winkel zwischen 64 und 66° liegt und vorteilhaft 65° ist.

3. Verfahren nach Anspruch 1 oder Anspruch 2, wobei ein oder mehrere der folgenden Bedingungen erfüllt sind:
- n=1,
- R_{1b}, R₁ₑ, R_{1d} und R₁ⱼ sind gleich und bedeuten H,
- R₁ₐ ist ausgewählt aus H, Cl, Methyl, Ethyl, n-Propyl, Isopropyl, tert.-Butyl, Trimethylsilan, Propen-3-yl und Ethanol,
- R₁ᵢ ist ausgewählt aus H, Methyl und Ethyl,

4. Verfahren nach Anspruch 2 oder Anspruch 3, wobei R₂ und R₃ gleich sind und ausgewählt sind aus Methyl und Ethyl.

5. Verfahren nach einem der vorhergehenden Ansprüche, wobei die metallorganische Platinverbindung aus der folgenden Liste ausgewählt ist:

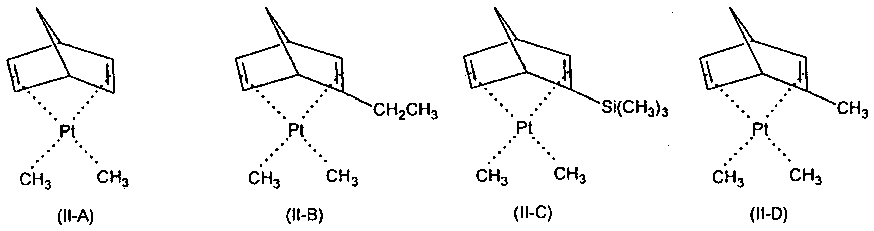

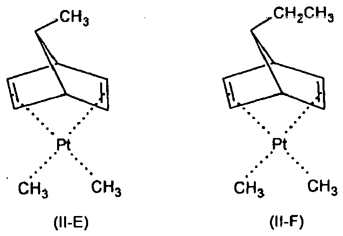

6. Verfahren nach einem der Ansprüche 1 bis 5, wobei der Träger, auf dem die Abscheidung eines Platinfilms oder von Platinpartikeln erfolgt, ausgewählt ist aus: supraleitendem Material mit hoher Tc, Keramik, hitzebeständigem Polymer, Glas, MgO, einem Perowskit wie LaAlO₃, Ni, Si, AsGa, InP, SiC, SiGe, und Gewebe mit einer mikroporösen Kohlenstoffdeckschicht.

7. Verfahren nach einem der Ansprüche 1 bis 6, wobei der Träger, auf dem die Abscheidung eines Platinfilms oder von Platinpartikeln erfolgt, ein oder mehrere Zwischenschichten umfasst, ausgewählt aus: metallischen Filmen, organischen Schichten, Diffusionsschichten, die aus wenigstens einem Material bestehen, das beispielsweise ausgewählt ist aus TiN, TiSiN, Ta, TaN, TaSiN, WN, WSiN, Kohlenstoff, Graphit und Nanoröhrchen.

8. Verfahren nach einem der Ansprüche 1 bis 7, wobei der Träger in einer Kammer platziert ist:
- unter neutraler Atmosphäre,
oder
- unter Sauerstoffatmosphäre, gegebenenfalls in Mischung mit einem neutralen Gas,
oder
- unter Ozonatmosphäre.

9. Verfahren nach einem der Ansprüche 1 bis 8, wobei der Träger wenigstens einer Aktivierung unterzogen wird, ausgewählt aus: Hitzeaktivierung, Laseraktivierung, UV-Aktivierung, Plasmaaktivierung, lonenstrahlaktivierung und Elektronenstrahlaktivierung.

10. Verfahren zur Herstellung eines elektronischen Bauelements, umfassend wenigstens einen Schritt der chemischen Gasphasenabscheidung von Platin gemäß einem der Ansprüche 1 bis 9.

11. Verfahren zur Herstellung eines festen Katalysators auf Basis von geträgertem Platin, umfassend wenigstens einen Schritt der chemischen Gasphasenabscheidung von Platin gemäß einem der Ansprüche 1 bis 9.

12. Verfahren zur Herstellung von Brennstoffzellen, umfassend wenigstens einen Schritt der chemischen Gasphasenabscheidung von Platin gemäß einem der Ansprüche 1 bis 9.

## Claims

1. Method of depositing a platinum film or platinum particles on a support, this method comprising at least one step of depositing platinum by chemical vapour deposition onto a support from at least one organometallic platinum compound, **characterised in that**:
- the organometallic platinum compound satisfies the following formula (II): 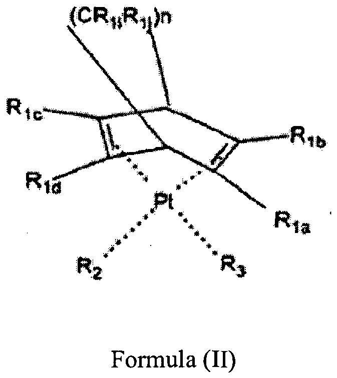 wherein:
- n represents an integer chosen from 1 and 2,
- when n = 1, R₁ᵢ, R₁ⱼ each represents only one group, when n = 2, R_{1j,} R₁ⱼ each represents two identical or different groups,
- R₁ₐ, R_{1b}, R_{1c}, R_{1d}, R₁ᵢ, R_{1j,} identical or different, are chosen from: H, a halogen atom, a C₁-C₄ alkyl group, a C₁-C₄ trialkyl silane group, a C₂ to C₄ alkenyl group, a C₁ to C₄ alkyl group carrying one or more OH functions,
R₂ and R₃ are each chosen independently of one another from C₁ to C₄ linear alkyls,
and
the organometallic platinum compound has a square planar structure in which the platinum is bonded to each of the C=C double bonds of the ligand forming an angle (C=C)-Pt-(C=C) of between 60 and 70°.

2. Method as claimed in claim 1, wherein the angle (C=C)-Pt-(C=C) is between 64 and 66° and advantageously equal to 65°.

3. Method as claimed in claim 1 or claim 2, wherein one or more of the following conditions is verified:
- n=1,
- R_{1b}, R_{1c}, R_{1d}, R₁ⱼ are all identical and represent H,
- R₁ₐ is chosen from: H, Cl, methyl, ethyl, n-propyl, isopropyl, tert-butyl, trimethyl silane, 3-propenyl, ethanol,
- R₁ᵢ is chosen from: H, methyl, ethyl.

4. Method as claimed in claim 2 or claim 3, wherein R₂ and R₃ are identical and are chosen from: methyl, ethyl.

5. Method as claimed in any one of the preceding claims, wherein the organometallic platinum compound is selected from the following list:

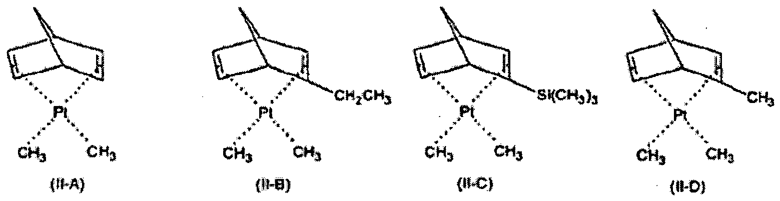

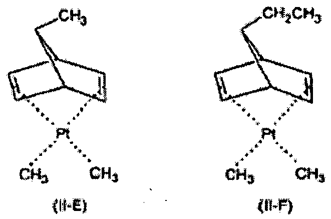

6. Method as claimed in any one of claims 1 to 5, wherein the support on which a platinum film or platinum particles are deposited is chosen from: a superconducting material with a high Tc, a ceramic, a heat-resistant polymer, a glass, MgO, a perovskite such as LaAlO₃, Ni, Si, AsGa, InP, SiC, SiGe, a textile comprising a microporous surface layer containing carbon.

7. Method as claimed in any one of claims 1 to 6, wherein which the support on which a platinum film or platinum particles are deposited comprises one or more intermediate layers chosen from: metal films, an organic layer, diffusion layers made from at least one material chosen, for example, from TiN, TiSiN, Ta, TaN, TaSiN, WN, WSiN, carbon, graphite, nanotubes.

8. Method as claimed in any one of claims 1 to 7, wherein the support is placed in an enclosure:
- under a neutral atmosphere,
or
- under an oxygen atmosphere optionally mixed with a neutral gas,
or
- under a hydrogen atmosphere,
or
- under an ozone atmosphere.

9. Method as claimed in any one of claims 1 to 8, wherein the support is subjected to at least one activation chosen from: a heat activation, activation by laser, activation by UV, activation by plasma, activation by ion beams, activation by electron beam.

10. Method of producing an electronic component comprising at least one step of chemical vapour deposition of platinum as claimed in any one of claims 1 to 9.

11. Method of producing a supported platinum-based solid catalyst comprising at least one step of chemical vapour deposition of platinum as claimed in any one of claims 1 to 9.

12. Method of producing fuel cells comprising at least one step of chemical vapour deposition of platinum as claimed in any one of claims 1 to 9.
